# EUROPEAN PATENT SPECIFICATION

(11) **EP 2 184 731 B1**
(45) Date of publication and mention of the grant of the patent: **25.01.2012**
(21) Application number: 09175396.2
(22) Date of filing: 09.11.2009
(51) Int. Cl.: G09G 3/32

(54) **Organic light emitting display device**
Organische lichtemittierende Anzeigevorrichtung
Dispositif d'affichage électroluminescent organique

(30) Priority: 07.11.2008 KR 20080110315
(43) Date of publication of application: 12.05.2010
(73) Proprietor: Samsung Mobile Display Co., Ltd., Yongin-City Gyeonggi-do (KR)
(72) Inventor: Lee, An-Su, Gyunggi-do (KR)
(74) Representative: Gulde Hengelhaupt Ziebig & Schneider

(56) References cited:
- US-A1- 2006 071 884
- US-A1- 2008 150 874

## Description

### BACKGROUND OF THE INVENTION

### 1. Field of the Invention

The present invention relates to an organic light emitting display device.

### 2. Description of Related Art

Recently, various types of flat panel display devices have been developed which have reduced weight and volume as compared to cathode ray tubes. The flat panel display devices include liquid crystal display devices, field emission display devices, plasma display devices, organic light emitting display devices, and others.

Among the flat panel display devices, organic light emitting display devices have excellent color reproducibility, slimness, and other advantages. Accordingly, it is widely used in a variety of applications such as PDAs and MP3 players, in addition to mobile phones.

An organic light emitting display device displays images using organic light emitting diodes (OLEDs) in which luminance is determined corresponding to an amount of current input to the OLEDs.

An organic light emitting diode includes an anode electrode, a cathode electrode, and a red, green or blue light emitting layer interposed between the anode and cathode electrodes. In the organic light emitting diode, luminance of light is determined depending on an amount of current flowing between the anode and cathode electrodes.

Red, green and blue light emitting layers are formed of different materials. Thus, although the same amount of current is applied to the red, green and blue light emitting layers, their light emitting efficiencies are different. Therefore, separate gammas are applied to the red, green and blue light emitting layers.

In a conventional organic light emitting display device, a data driver is generally positioned at a side of a panel, i.e., along an upper or lower portion of the panel. Here, the data driver applies data signals to respective pixels provided in the panel. When the data driver is positioned at a lower portion of the panel, it is assumed that the data driver has 33 pins, and the 33 pins are sequentially numbered from left to right. Then, red, green and blue data are repeatedly output sequentially from a first pin to a thirty-third pin. When the data driver is positioned at an upper portion of the panel, the order of pin numbers is changed, and red, green and blue data are repeatedly output sequentially from the thirty-third pin to the first pin.

At this time, separate gammas are applied to the respective pins. When the data driving unit is positioned at the lower portion of the panel, a red gamma is applied to a first pin, a fourth pin, a seventh pin, ..., a green gamma is applied to a second pin, a fifth pin, an eighth pin, ..., and a blue gamma is applied to a third pin, a sixth pin, a ninth pin, .... That is, gammas suitable for the respective colors are applied to data output through respective lines.

However, when the same data driver is positioned at an upper portion of the panel, the order of the pin numbers is changed. Therefore, colors of data do not correspond to the gammas. That is, the red gamma is applied to the first pin, the fourth pin, the seventh pin, ..., the green gamma is applied to the second pin, the fifth pin, the eighth pin, ..., and the blue gamma is applied to the third pin, the sixth pin, the ninth pin, .... However, blue data are output through the first pin, the fourth pin, the seventh pin, ..., green data are output through the second pin, the fifth pin, the eighth pin, ..., and red data are output through the third pin, the sixth pin, the ninth pin, .... Therefore, when this data driver is positioned at the upper portion of the panel, luminance and/or white balance is compromised. Accordingly, the data driver is designed differently depending on positions of the panel in which the data driver is mounted. For this reason, manufacturing cost is increased.

United States Patent Application Publication US 2006/0071884 A1 discloses an organic light emitting display comprising a data driver for supplying data signals to first data lines, an image display portion with second data lines and a demultiplexer with data transistors arranged in the first data lines to supply the data signals supplied to the first data lines to the second data lines, as well as capacitors connected between gate terminals of data transistors and the second data lines. An embodiment is disclosed in which there is a plurality of demultiplexers, and the data lines are grouped correspondingly.

United States Patent Application Publication US 2008/0150874 A1 discloses a liquid crystal display in which signal lines are driven based on time division and the switching of voltage-dividing resistors used for generating reference voltages is linked with this time-division driving.

### SUMMARY OF THE INVENTION

Accordingly, the present invention provides an organic light emitting display device as set forth in claim 1 which allows a position of a data driver mounted in the display device to be freely set. Preferred embodiments are subject of the dependent claims 2 through 6.

### BRIEF DESCRIPTION OF THE DRAWINGS

The accompanying drawings illustrate exemplary embodiments of the present invention, and, together with the description, serve to explain the principles of the present invention.

FIG. 1 is a schematic block diagram showing the structure of an organic light emitting display device according to an embodiment of the present invention.

FIG. 2 shows an embodiment of a connection of first and second demultiplexer units employed in the organic light emitting display device according to aspects of the present invention.

FIG. 3 is a timing diagram showing signals input to the organic light emitting display device of FIG. 2.

FIG. 4 shows a reference example of the connection of the first and second demultiplexer units employed in the organic light emitting display device.

FIG. 5 is a timing diagram showing signals input to the organic light emitting display device of FIG. 4.

### DETAILED DESCRIPTION OF EXEMPLARY EMBODIMENTS

Hereinafter, an exemplary embodiment according to the present invention will be described with reference to the accompanying drawings. Here, when a first element is described as being coupled to a second element, the first element may be directly coupled to the second element or may be indirectly coupled to the second element via one or more additional elements. Further, some of the elements that are not essential to the complete understanding of the invention are omitted for clarity. Also, like reference numerals refer to like elements throughout.

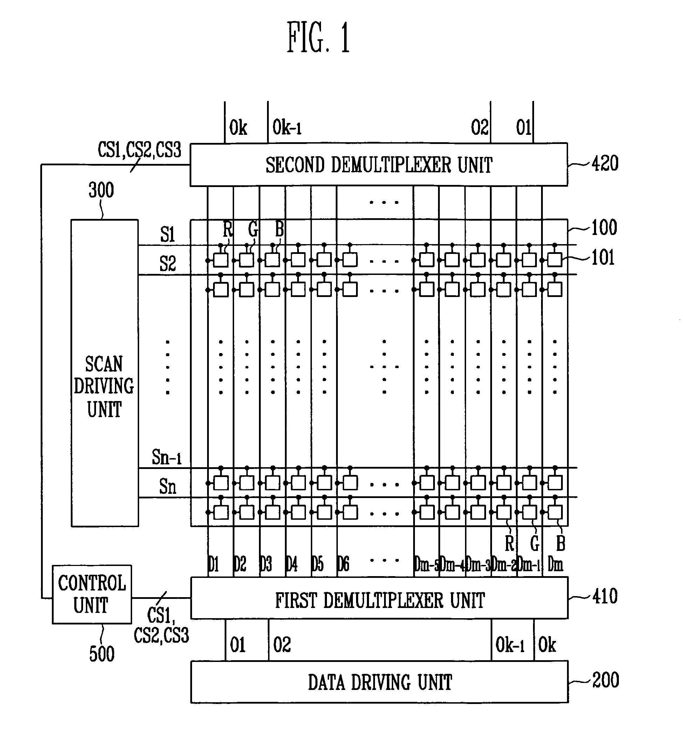

FIG 1 is a schematic block diagram showing the structure of an organic light emitting display device according to an embodiment of the present invention.

Referring to FIG. 1, the organic light emitting display device includes a display unit 100, a data driver 200, a scan driver 300, a first demultiplexer unit 410, a second demultiplexer unit 420 and a controller 500.

A plurality of pixels 101 are arranged in the display unit 100, and each of the pixels 101 includes an organic light emitting diode (not shown). The display unit 100 includes n scan lines S1, S2, ..., Sn-1 and Sn, and m data lines D1, D2, ..., Dm-1 and Dm. Here, the n scan lines S1, S2, ..., Sn-1 and Sn extend in a row direction and supply scan signals. The m data lines D1, D2, ..., Dm-1 and Dm extend in a column direction and supply data signals.

The display unit 100 is driven by receiving first and second power sources. In the display unit 100, current flows through the organic light emitting diodes by utilizing scan signals, data signals, light emission signals and the first and second power sources, so that the display unit 100 emits light to display images. The plurality of pixels includes red, green and blue sub-pixels, R, G and B.

The data driver 200 generates data signals using image signals (R, G and B data signals) having red, green and blue components. The data driver 200 applies data signals output through output channels O1, O2, ..., Ok-1 and Ok to the display unit 100. Here, the output channels O1, O2, ..., Ok-1 and Ok are connected to the data lines D1, D2, ..., Dm-1 and Dm of the display unit 100. The data driver 200 sequentially outputs three data signals from each output channel. That is, red, green and blue data signals are sequentially output from each output channel of the data driver 200, so that the number of output channels of the data driver 200 can be decreased.

The data driver 200 is positioned above or below the display unit 100. When the data driver 200 is positioned below the display unit 100 as shown in FIG. 1, the data driver 200 is coupled to the display unit 100 through the first demultiplexer unit 410. When the data driver 200 is positioned above the display unit 100, the data driver 200 is coupled to the display unit 100 through the second demultiplexer 420.

In the embodiment of the present invention, the data driver 200 positioned below the display unit 100 will be described as an example.

The scan driver 300 generates scan signals. The scan driver 300 is connected to the scan lines S1, S2, ..., Sn-1 and Sn, and supplies a scan signal to specific rows of the display unit 100. A data signal output from the data driver 200 is supplied to a pixel 101 receiving the scan signal, and a voltage corresponding to the data signal is applied to the pixel 101.

Each of the first and second demultiplexer units includes a plurality of demultiplexers. The respective demultiplexers divide the plurality of data lines into a plurality of groups, and each of the groups is coupled to an output channel of the data driver 200 through a demultiplexer. In other words, an output channel of the data driver 200 is coupled to a demultiplexer so that the output channel is coupled to three data lines through the demultiplexer. Data signals of three different colors are output from the output channel, and each of the data signals is supplied to a corresponding data line by the demultiplexer.

Operations of the first and second demultiplexer units 410 and 420 will now be described. When red, green and blue data signals are output from an output channel of the data driver 200, the first or second demultiplexer unit 410 or 420 time-divisionally controls a connection sequence between the plurality of data lines and the output channels in accordance with timing of the output data signals, so that the red, green and blue data signals output from the output channel are transmitted to data lines coupled to red, green and blue pixels, respectively. Therefore, although red, green and blue gammas are individually used, red data are provided only to red pixels, green data are provided only to green pixels, and blue data are provided only to blue pixels, depending on operation of the first or second demultiplexer 410 or 420. Accordingly, luminance or white balance is not lost due to the mismatch of gammas.

The controller 500 controls the first and second demultiplexer units 410 and 420. The controller 500 generates control signals depending on whether the data driver 200 is positioned above or below the display unit 100. Accordingly, the controller 500 controls data signals output from the data driver 200 to be applied to data lines coupled to the pixels.

Hereinafter, a connection of the display unit 100, the first and second demultiplexer units 410 and 420 and the data driver 200 will be described in detail.

Each of the plurality of pixels constituting the display unit 100 includes three sub-pixels, i.e., red, green and blue sub-pixels, R, G and B. The respective sub-pixels R, G and B are coupled to data lines and receive data signals through the data lines, respectively.

The respective pixels 101 have red, green and blue sub-pixels, R, G and B repeatedly positioned from left to right of the display unit 100.

The data driver 200 is coupled to the display unit 100 in one of two configurations. In a first configuration, the output channels O1, O2, ..., Ok-1 and Ok of the data driver 200 sequentially output red, green and blue data signals. In a second configuration, the output channels O1, O2, ..., Ok-1 and Ok of the data driver 200 sequentially output blue, green and red data signals.

In the first configuration, the data driver 200 is positioned below the display unit 100. In the second configuration, the data driver 200 is positioned above the display unit 100. Here, since the data driver 200 is designed to be positioned above the pixel unit 100 in the second configuration, the order of the output channels numbered from left to right is reversed as compared to the first configuration.

In the first configuration, the output channels of the data driver 200 are arranged from left to right in the order of a first output channel, a second output channel, ..., a (k-1)-th output channel and a k-th output channel, O1, O2, ..., Ok-1 and Ok. In the display unit 100, red, green and blue pixels are repeatedly positioned from left to right of the display unit 100. Therefore, if red, green and blue data are sequentially output from an output channel, the first demultiplexer unit 410 allows the red, green and blue data to be respectively provided to red, green and blue pixels, R, G and B.

However, in the second configuration, the operation of the data driver 200 is reversed as compared to the first configuration. Therefore, the output channels of the data driver 200 are arranged from left to right directions in the order of a k-th output channel, a (k-1)-th output channel, ..., a second output channel and a first output channel, Ok, Ok-1, ..., O2 and O1, If red, green and blue data are sequentially output from an output channel, the second demultiplexer unit 420 allows the red, green and blue data to be respectively provided to red, green and blue pixels, R, G and B. Further, if blue, green and red data are sequentially output from an output channel, the second demultiplexer unit 420 allows the blue, green and red data to be respectively provided to blue, green and red pixels, B, G and R through control of the controller 500.

That is, red, green and blue data output from an output channel are respectively provided to red, green and blue pixels R, G and B by an operation of either the first or second demultiplexer unit 410 or 420, regardless of the position of the data driver 200.

Therefore, red, green and blue gammas are correctly applied to the red, green and blue data regardless of the position of the data driver 200. Accordingly, suitable gammas are respectively applied to data signals and pixels, so that white balance is not lost.

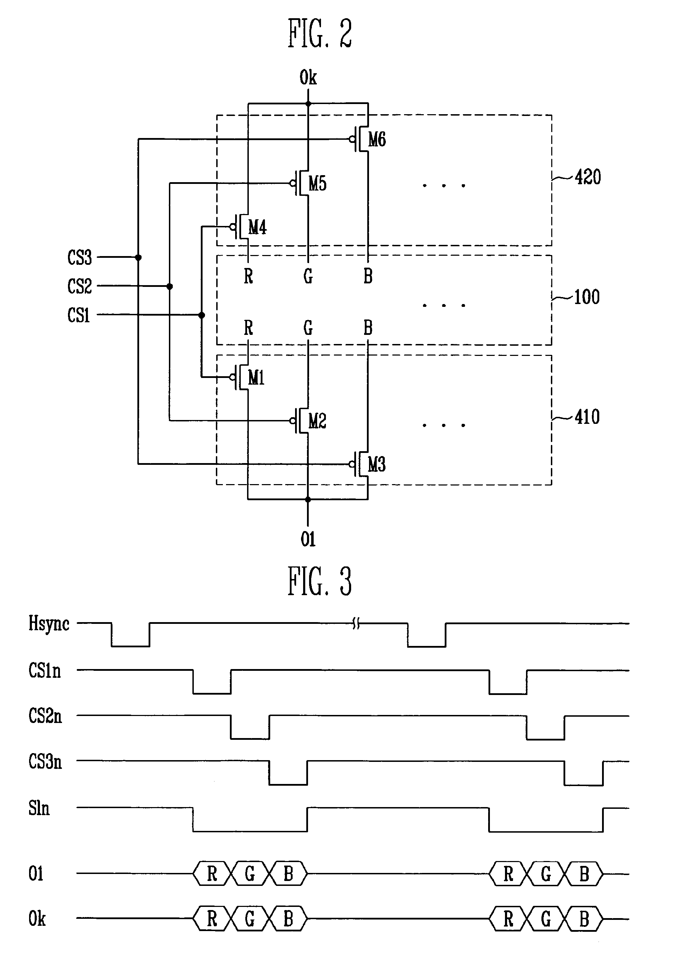

FIG. 2 shows an embodiment of a connection of the first and second demultiplexer units employed in the organic light emitting display device according to aspects of the present invention. FIG. 3 is a timing diagram showing signals input to the organic light emitting display device of FIG. 2. The connection of the first and second demultiplexer units 410 and 420 will be described below with reference to FIGS. 2 and 3.

In the embodiment, red, green and blue data are sequentially output from an output channel regardless of the position of the data driver 200.

The first demultiplexer unit 410 is formed below the display unit 100 and includes first to third transistors, M1, M2 and M3.

A first electrode of the first transistor M1 is coupled to an output channel O1 through which data signals are output, and a second electrode of the first transistor M1 is coupled to a data line coupled to a red pixel R. A gate electrode of the first transistor M1 is coupled to a first control line CS1 through which a first control signal CS1 n is supplied.

A first electrode of the second transistor M2 is coupled to the output channel 01, and a second electrode of the second transistor M2 is coupled to a data line coupled to a green pixel G. A gate electrode of the second transistor M2 is coupled to a second control line CS2 through which a second control signal CS2n is supplied.

A first electrode of the third transistor M3 is the output channel O1, and a second electrode of the third transistor M3 is coupled to a data line coupled to a blue pixel B. A gate electrode of the third transistor M3 is coupled to a third control line CS3 through which a third control signal CS3n is supplied.

The second demultiplexer unit 420 is formed above the display unit 100 and includes fourth to sixth transistors, M4, M5 and M6.

A first electrode of the fourth transistor M4 is coupled to an output channel Ok through which data signals are output, and a second electrode of the fourth transistor M4 is coupled to a data line coupled to a red pixel R. A gate electrode of the fourth transistor M4 is coupled to the first control line CS1 through which the first control signal CS1 n is supplied.

A first electrode of the fifth transistor M5 is coupled to the output channel Ok, and a second electrode of the fifth transistor M5 is coupled to a data line coupled to a green pixel G. A gate electrode of the fifth transistor M5 is coupled to the second control line CS2 through which the second control signal CS2n is supplied.

A first electrode of the sixth transistor M6 is coupled to the output channel Ok, and a second electrode of the sixth transistor M6 is coupled to a data line coupled to a blue pixel B. A gate electrode of the sixth transistor M6 is coupled to the third control line CS3 through which the third control signal CS3n is supplied.

The first and second electrodes of each of the transistors are source and drain electrodes. If the first electrode is a source electrode, the second electrode is a drain electrode. If the first electrode is a drain electrode, the second electrode is a source electrode.

Operations of the first and second demultiplexer unit 410 and 420 will now be described. The first, second and third control signals CS1 n, CS2n and CS3n sequentially become low states when a scan signal Sln maintains a low state, which occurs after a horizontal synchronization signal Hsync becomes a low state. After that, the first, second and third control signals CS1 n, CS2n and CS3n sequentially become low states again when a scan signal Sln again becomes a low state, after a subsequent horizontal synchronization signal Hsync becomes a low state. The data signals are divided into red, green and blue data signals, and each of the data signals is supplied while the corresponding one of the control signals maintains a low state.

First, when the first control signal CS1 n becomes a low state, the first and fourth transistors M1 and M4 are turned on. At this time, a red data signal is output to the output channels O1 and Ok of the data driver 200. If the data driver 200 is positioned below the display unit 100, the red data signal is provided to a red pixel R through a data line via the first transistor M1. If the data driver 200 is positioned above the display unit 100, the red data signal is provided to a red pixel R through a data line via the fourth transistor M4.

When the second control signal CS2n becomes a low state, the second and fifth transistors M2 and M5 are turned on. At this time, a green data signal is output to the output channels O1 and Ok of the data driver 200. If the data driver 200 is positioned below the display unit 100, the green data signal is provided to a green pixel G through a data line via the second transistor M2. If the data driver 200 is positioned above the display unit 100, the green data signal is provided to a green pixel G through a data line via the fifth transistor M5.

When the third control signal CS3n becomes a low state, the third and sixth transistors M3 and M6 are turned on. At this time, a blue data signal is output to the output channels O1 and Ok of the data driver 200. If the data driver 200 is positioned below the display unit 100, the blue data signal is provided to a blue pixel G through a data line via the third transistor M3. If the data driver 200 is positioned above the display unit 100, the blue data signal is provided to a blue pixel G through a data line via the sixth transistor M6.

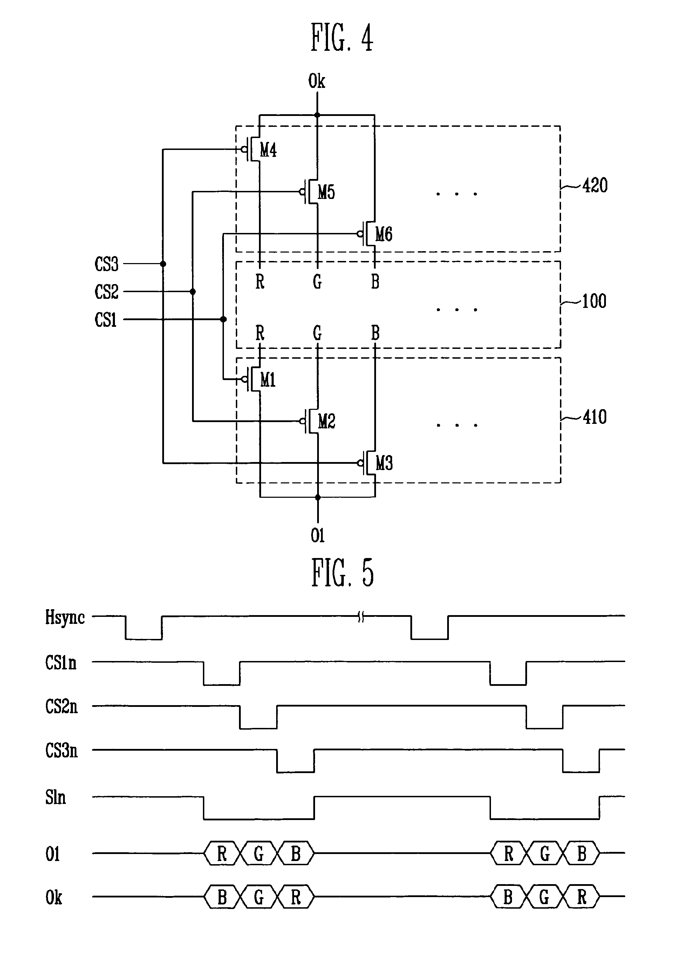

FIG. 4 shows a reference example of the connection of the first and second demultiplexer units employed in the organic light emitting display device. FIG. 5 is a timing diagram showing signals input to the organic light emitting display device of FIG. 4. The connection of the first and second demultiplexer units 410 and 420 will be described below with reference to FIGS. 4 and 5.

The order of red, green and blue data output from an output channel is reversed depending on whether the data driver 200 is positioned above or below the display unit 100.

The first demultiplexer unit 410 is formed below the display unit 100 and includes first to third transistors, M1, M2 and M3.

A first electrode of the first transistor M1 is coupled to an output channel O1 through which data signals are output, and a second electrode of the first transistor M1 is coupled to a data line coupled to a red pixel R. A gate electrode of the first transistor M1 is coupled to a first control line CS1 through which a first control signal CS1 n is supplied.

A first electrode of the second transistor M2 is coupled to the output channel O1, and a second electrode of the second transistor M2 is coupled to a data line coupled to a green pixel G. A gate electrode of the second transistor M2 is coupled to a second control line CS2 through which a second control signal CS2n is supplied.

A first electrode of the third transistor M3 is coupled to the output channel O1, and a second electrode of the third transistor M3 is coupled to a data line coupled to a blue pixel B. A gate electrode of the third transistor M3 is coupled to a third control line CS3 through which a third control signal CS3n is supplied.

The second demultiplexer unit 420 is formed above the display unit 100 and includes fourth to sixth transistors, M4, M5 and M6.

A first electrode of the fourth transistor M4 is coupled to an output channel Ok through which data signals are output, and a second electrode of the fourth transistor M4 is coupled to a data line coupled to a red pixel R. A gate electrode of the fourth transistor M4 is coupled to the third control line CS3 through which the third control signal CS3n is supplied.

A first electrode of the fifth transistor M5 is coupled to the output channel Ok, and a second electrode of the fifth transistor M5 is coupled to a data line coupled to a green pixel G. A gate electrode of the fifth transistor M5 is coupled to the second control line CS2 through which the second control signal CS2n is supplied.

A first electrode of the sixth transistor M6 is coupled to the output channel Ok, and a second electrode of the sixth transistor M6 is coupled to a data line coupled to a blue pixel B. A gate electrode of the sixth transistor M6 is coupled to the first control line CS1 through which the first control signal CS1 n is supplied.

Operations of the first and second demultiplexer unit 410 and 420 will now be described. The first, second and third control signals CS1 n, CS2n and CS3n sequentially become low states when a scan signal Sln maintains a low state, which occurs after a horizontal synchronization signal Hsync becomes a low state. After that, the first, second and third control signals CS1n, CS2n and CS3n sequentially become low states again when a scan signal Sln again becomes a low state, after a subsequent horizontal synchronization signal Hsync becomes a low state. The data signals are divided into red, green and blue data signals, and each of the data signals is supplied while the corresponding one of the control signals maintains a low state.

First, when the first control signal CS1 n becomes a low state, the first and sixth transistors M1 and M6 are turned on. At this time, if the data driver 200 is positioned below the display unit 100, a red data signal is output to the output channel O1 of the data driver 200. If the data driver 200 is positioned above the display unit 100, a blue data signal is output to the output channel Ok of the data driver 200. Therefore, if the data driver 200 is positioned below the display unit 100, the red data signal is provided to a red pixel R through a data line via the first transistor M1. If the data driver 200 is positioned above the display unit 100, the blue data is provided to a blue pixel B through a data line via the sixth transistor M6.

When the second control signal CS2n becomes a low state, the second and fifth transistors M2 and M5 are turned on. At this time, a green data signal is output to the output channels O1 and Ok of the data driver 200, regardless of the position of the data driver 200. If the data driver 200 is positioned below the display unit 100, the green data signal is provided to a green pixel G through a data line via the second transistor M2. If the data driver 200 is positioned above the display unit 100, the green data signal is provided to a green pixel G through a data line via the fifth transistor M5.

When the third control signal CS3n becomes a low state, the third and fourth transistors M3 and M4 are turned on. At this time, if the data driver 200 is positioned below the display unit 100, a blue data signal is output to the output channel O1 of the data driver 200. If the data driver 200 is positioned above the display unit 100, a red data signal is output to the output channel Ok of the data driver 200. Therefore, if the data driver 200 is positioned below the display unit 100, the blue data signal is provided to a blue pixel B through a data line via the third transistor M3. If the data driver 200 is positioned above the display unit 100, the red data signal is provided to a red pixel R through a data line via the fourth transistor M4.

## Claims

1. An organic light emitting display device, comprising:
a display unit (100) comprising a plurality of data lines (D1, ..., Dm) extending in a first direction, a plurality of scan lines (S1, ..., Sn) extending in a second direction crossing the first direction, and pixels (101) disposed at crossing regions of the plurality of data lines (D1, ..., Dm) and the plurality of scan lines (S1, ..., Sn), wherein the plurality of data lines (D1, ..., Dm) are arranged into a plurality of groups;
a data driver (200) adapted to supply red, green and blue data signals to a plurality of output channels (O1 ..., Ok);
a first demultiplexer (410) at a first side of the display unit (100), the first demultiplexer (410) being adapted to associate each of the groups of data lines (D1, ..., Dm) to respective first output channels (O1 ..., Ok) of the data driver (200), and to couple the first output channels (O1 ..., Ok) to the data lines (D1, ..., Dm) in the corresponding group in accordance with control signals (CS1, CS2, CS3);
a second demultiplexer (420) at a second side of the display unit (100) opposite the first side, the second demultiplexer (420) being adapted to associate each of the groups to respective second output channels (O1, ..., Ok) of the data driver (200), and to couple the second output channels (O1, ..., Ok) to the data lines (D1, ..., Dm) in the corresponding group in accordance with the control signals (CS1, CS2, CS3); and
a controller (500) adapted to output the control signals (CS1, CS2, CS3),
wherein the data driver (200) is either arranged at the first side and coupled to the first demultiplexer (410), or at the second side and coupled to the second demultiplexer (420), and wherein
the first demultiplexer (410) comprises a first transistor (M1) coupled to the data line corresponding to the red pixel (R), a second transistor (M2) coupled to the data line corresponding to the green pixel (G), and a third transistor (M3) coupled to the data line corresponding to the blue pixel (B), wherein the second demultiplexer (420) comprises a fourth transistor (M4) coupled to the data line corresponding to the red pixel (R), a fifth transistor (M5) coupled to the data line corresponding to the green pixel (G), and a sixth transistor (M6) coupled to the data line corresponding to the blue pixel (B), and **characterised in that** gate electrodes of the first and fourth transistors (M1, M4) are coupled together, gate electrodes of the second and fifth transistors (M2, M5) are coupled together, and gate electrodes of the third and sixth transistors (M3, M6) are coupled together, and wherein the control signals (CS1, CS2, CS3) are supplied to the respective gate electrodes for controlling the corresponding transistors (M1, ..., M6).

2. The organic light emitting display device of claim 1, wherein the data driver (200) is adapted to sequentially output red, green and blue data signals through the output channels (O1 ..., Ok) during a horizontal period.

3. The organic light emitting display device of one of the claims 1 or 2, wherein the data driver (200) is positioned at the second side and coupled to the second demultiplexer (420), the data driver (200) being further adapted to sequentially output blue, green and red data signals through the output channels (O1, ..., Ok) during a horizontal period.

4. The organic light emitting display device of one of the preceding claims, wherein the first demultiplexer (410) and the second demultiplexer (420) are each configured to supply data signals to all of the plurality of data lines (D1, ..., Dm).

5. The organic light emitting display device of one of the preceding claims, wherein the data driver (200) is adapted to sequentially supply red, green and blue data signals, and wherein the first demultiplexer (410) or the second demultiplexer (420) are configured to supply the red data signals to a data line corresponding to a red pixel (R) of the pixels (101) from among the plurality of data lines (D1, ..., Dm), to supply the green data signals to a data line corresponding to a green pixel (G) of the pixels (101) from among the plurality of data lines (D1, ..., Dm), and to supply the blue data signals to a data line corresponding to a blue pixel (B) of the pixels (101) from among the plurality of data lines (D1, ..., Dm).

6. The organic light emitting display device of one of the preceding claims, wherein the first through six transistors (M1, ..., M6) are of a same polarity type.

## Patentansprüche

1. Organische lichtemittierende Anzeigevorrichtung, umfassend:
eine Anzeigeeinheit (100), umfassend eine Vielzahl von Datenleitungen (D1, ..., Dm), welche sich in eine erste Richtung erstrecken, eine Vielzahl von Abtastleitungen (S1, ..., Sn), welche sich in eine zweite Richtung erstrecken, welche die erste Richtung kreuzt, und Pixel (101), welche an Kreuzungsbereichen der Vielzahl von Datenleitungen (D1, ..., Dm) und der Vielzahl von Abtastleitungen (S1, ..., Sn) angeordnet sind, wobei die Vielzahl von Datenleitungen (D1, ..., Dm) in mehreren Gruppen angeordnet ist;
einen Datentreiber (200), welcher eingerichtet ist, rote, grüne und blaue Datensignale an eine Vielzahl von Ausgabekanälen (O1, .., Ok) zu liefern;
einen ersten Demultiplexer (410) an einer ersten Seite der Anzeigeeinheit (100), wobei der erste Demultiplexer (410) eingerichtet ist, jede der Gruppen von Datenleitungen (D1, ..., Dm) jeweiligen ersten Ausgabekanälen (O1, .., Ok) des Datentreibers (200) zuzuordnen und die ersten Ausgabekanäle (O1, ..., Ok) mit den Datenleitungen (D1, ..., Dm) in der entsprechenden Gruppe gemäß Steuerungssignalen (CS1, CS2, CS3) zu koppeln;
einen zweiten Demultiplexer (420) an einer zweiten Seite der Anzeigeeinheit (100),welche der ersten Seite gegenüberliegt, wobei der zweite Demultiplexer (420) eingerichtet ist, jede der Gruppen jeweiligen zweiten Ausgabekanälen (O1, .., Ok) des Datentreibers (200) zuzuordnen und die zweiten Ausgabekanäle (O1, ..., Ok) mit den Datenleitungen (D1, ..., Dm) in der entsprechenden Gruppe gemäß den Steuerungssignalen (CS1, CS2, CS3) zu koppeln; und
eine Steuerung (500), welche eingerichtet ist, die Steuerungssignale (CS1, CS2, CS3) auszugeben,
wobei der Datentreiber (200) entweder an der ersten Seite angeordnet und an den ersten Demultiplexer (410) angeschlossen ist oder an der zweiten Seite angeordnet und an den zweiten Demultiplexer (420) angeschlossen ist und wobei
der erste Demultiplexer (410) einen ersten Transistor (M1), welcher an die Datenleitung entsprechend dem roten Pixel (R) angeschlossen ist, einen zweiten Transistor (M2), welcher an die Datenleitung entsprechend dem grünen Pixel (G) angeschlossen ist, und einen dritten Transistor (M3) umfasst, welcher an die Datenleitung entsprechend dem blauen Pixel (B) angeschlossen ist, wobei der zweite Demultiplexer (420) einen vierten Transistor (M4), welcher an die Datenleitung entsprechend dem roten Pixel (R) angeschlossen ist, einen fünften Transistor (M5), welcher an die Datenleitung entsprechend dem grünen Pixel (G) angeschlossen ist, und einen sechsten Transistor (M6) umfasst, welcher an die Datenleitung entsprechend dem blauen Pixel (B) angeschlossen ist, und **dadurch gekennzeichnet ist, dass** Gate-Elektroden des ersten und des vierten Transistors (M1, M4) miteinander verbunden sind, Gate-Elektroden des zweiten und des fünften Transistors (M2, M5) miteinander verbunden sind und Gate-Elektroden des dritten und des sechsten Transistors (M3, M6) miteinander verbunden sind, und wobei die Steuerungssignale (CS1, CS2, CS3) an die jeweiligen Gate-Elektroden zum Steuern der entsprechenden Transistoren (M1, ..., M6) geliefert werden.

2. Organische lichtemittierende Anzeigevorrichtung nach Anspruch 1, wobei der Datentreiber (200) eingerichtet ist, nach einander rote, grüne und blaue Datensignale durch die Ausgabekanäle (O1, ..., Ok) während einer Horizontalperiode auszugeben.

3. Organische lichtemittierende Anzeigevorrichtung nach einem der Ansprüche 1 oder 2, wobei der Datentreiber (200) an der zweiten Seite angeordnet ist und an den zweiten Demultiplexer (420) angeschlossen ist, wobei der Datentreiber (200) weiterhin eingerichtet ist, nacheinander blaue, grüne und rote Datensignale durch die Ausgabekanäle (O1, ..., Ok) während einer Horizontalperiode auszugeben.

4. Organische lichtemittierende Anzeigevorrichtung nach einem der vorhergehenden Ansprüche, wobei der erste Demultiplexer (410) und der zweiter Demultiplexer (420) jeweils konfiguriert sind, Datensignale an alle der Vielzahl von Datenleitungen (D1, ..., Dm) zu liefern.

5. Organische lichtemittierende Anzeigevorrichtung nach einem der vorhergehenden Ansprüche, wobei der Datentreiber (200) eingerichtet ist, nacheinander rote, grüne und blaue Datensignale zu liefern, und wobei der erste Demultiplexer (410) oder der zweite Demultiplexer (420) konfiguriert sind, die roten Datensignale an eine Datenleitung entsprechend einem roten Pixel (R) der Pixel (101) der Vielzahl von Datenleitungen (D1, ..., Dm) zu liefern, die grünen Datensignale an eine Datenleitung entsprechend einem grünen Pixel (G) der Pixel (101) der Vielzahl von Datenleitungen (D1, ..., Dm) zu liefern und die blauen Datensignale an eine Datenleitung entsprechend einem blauen Pixel (B) der Pixel (101) der Vielzahl von Datenleitungen (D1, ..., Dm) zu liefern.

6. Organische lichtemittierende Anzeigevorrichtung nach einem der vorhergehenden Ansprüche, wobei der erste bis sechste Transistor (M1, ..., M6) von einem gleichen Polaritätstyp sind.

## Revendications

1. Dispositif d'affichage à émission de lumière organique, comprenant :
une unité d'affichage (100) comprenant une pluralité de lignes de données (D1, ..., Dm) s'étendant dans une première direction, une pluralité de lignes de balayage (S1, ..., Sn) s'étendant dans une deuxième direction croisant la et des pixels (101) disposés dans des régions de croisement de la pluralité de lignes de données (D1, ..., Dm) et de la pluralité de lignes de balayage (S1, ..., Sn), la pluralité de lignes de données (D1, ..., Dm) étant agencées en une pluralité de groupes ;
un dispositif d'attaque de données (200) adapté de façon à délivrer des signaux de données rouges, verts et bleus à une pluralité de canaux de sortie (O1, ..., Ok) ;
un premier démultiplexeur (410) d'un premier côté de l'unité d'affichage (100), le premier démultiplexeur (410) étant adapté de façon à associer chacun des groupes de lignes de données (D1, ..., Dm) à des premiers canaux de sortie respectifs (O1, ..., Ok) du dispositif d'attaque de données (200) et à coupler les premiers canaux de sortie (O1, ..., Ok) aux lignes de données (D1, ..., Dm) dans le groupe correspondant en fonction de signaux de commande (CS1, CS2, CS3) ;
un deuxième démultiplexeur (420) d'un deuxième côté de l'unité d'affichage (100) opposé au premier côté, le deuxième démultiplexeur (420) étant adapté de façon à associer chacun des groupes à des deuxièmes canaux de sortie respectifs (O1, ..., Ok) du dispositif d'attaque de données (200) et à coupler les deuxièmes canaux de sortie (O1, ..., Ok) aux lignes de données (D1, ..., Dm) dans le groupe correspondant en fonction des signaux de commande (CS1, CS2, CS3) ; et
un dispositif de commande (500) adapté de façon à délivrer en sortie les signaux de commande (CS1, CS2, CS3),
dans lequel le dispositif d'attaque de données (200) est disposé soit du premier côté et couplé au premier démultiplexeur (410), soit du deuxième côté et couplé au deuxième démultiplexeur (420), et dans lequel :
le premier démultiplexeur (410) comprend un premier transistor (M1) couplé à la ligne de données correspondant au pixel rouge (R), un deuxième transistor (M2) couplé à la ligne de données correspondant au pixel vert (G) et un troisième transistor (M3) couplé à la ligne de données correspondant au pixel bleu (B), dans lequel le deuxième démultiplexeur (420) comprend un quatrième transistor (M4) couplé à la ligne de données correspondant au pixel rouge (R), un cinquième transistor (M5) couplé à la ligne de données correspondant au pixel vert (G) et un sixième transistor (M6) couplé à la ligne de données correspondant au pixel bleu (B), et **caractérisé en ce que** des électrodes de grille des premier et quatrième transistors (M1, M4) sont couplées ensemble, des électrodes de grille des deuxième et cinquième transistors (M2, M5) sont couplées ensemble, et des électrodes de grille des troisième et sixième transistors (M3, M6) sont couplées ensemble, et dans lequel les signaux de commande (CS1, CS2, CS3) sont délivrés aux électrodes de grille respectives pour commander les transistors correspondants (M1, ..., M6).

2. Dispositif d'affichage à émission de lumière organique selon la revendication 1, dans lequel le dispositif d'attaque de données (200) est adapté de façon à délivrer en sortie en séquence des signaux de données rouges, verts et bleus par l'intermédiaire des canaux de sortie (O1 ..., Ok) durant une période horizontale.

3. Dispositif d'affichage à émission de lumière organique selon l'une des revendications 1 et 2, dans lequel le dispositif d'attaque de données (200) est positionné d'un deuxième côté et couplé au deuxième démultiplexeur (420), le dispositif d'attaque de données (200) étant de plus adapté de façon à délivrer en sortie en séquence des signaux de données bleus, verts et rouges par l'intermédiaire des canaux de sortie (O1, ..., Ok) durant une période horizontale.

4. Dispositif d'affichage à émission de lumière organique selon l'une des revendications précédentes, dans lequel le premier démultiplexeur (410) et le deuxième démultiplexeur (420) sont chacun configurés de façon à délivrer des signaux de données à la totalité de la pluralité de lignes de données (D1, ..., Dm).

5. Dispositif d'affichage à émission de lumière organique selon l'une des revendications précédentes, dans lequel le dispositif d'attaque de données (200) est adapté de façon à délivrer en séquence des signaux de données rouges, verts et bleus, et dans lequel le premier démultiplexeur (410) ou le deuxième démultiplexeur (420) sont configurés de façon à délivrer les signaux de données rouges à une ligne de données correspondant à un pixel rouge (R) des pixels (101) parmi la pluralité de lignes de données (D1, ..., Dm), à délivrer les signaux de données verts à une ligne de données correspondant à un pixel vert (G) des pixels (101) parmi la pluralité de lignes de données (D1, ..., Dm) et à délivrer les signaux de données bleus à une ligne de données correspondant à un pixel bleu (B) des pixels (101) parmi la lignes de données (D1, ..., Dm).

6. Dispositif d'affichage à émission de lumière organique selon l'une des revendications précédentes, dans lequel les premier à sixième transistors (M1, ..., M6) sont d'un même type de polarité.
